# EUROPEAN PATENT SPECIFICATION

(11) **EP 1 815 527 B1**
(45) Date of publication and mention of the grant of the patent: **23.05.2012**
(21) Application number: 05791157.0
(22) Date of filing: 13.10.2005
(51) Int. Cl.: H01L 29/786, H01L 29/78

(54) **A MOSFET FOR HIGH VOLTAGE APPLICATIONS AND A METHOD OF FABRICATING SAME**
MOSFET FÜR HOCHSPANNUNGSANWENDUNGEN UND VERFAHREN ZU SEINER HERSTELLUNG
MOSFET POUR APPLICATIONS HAUTE TENSION ET PROCEDE DE FABRICATION CORRESPONDANT

(30) Priority: 14.10.2004 EP 04105042
(43) Date of publication of application: 08.08.2007
(73) Proprietor: NXP B.V., 5656 AG Eindhoven (NL)
(72) Inventor: KONING, Jan, J., NL-5656 AA Eindhoven (NL); NIELAND, Jan-Harm, NL-5656 AA Eindhoven (NL); EGBERS, Johannes, H., H., A., NL-5656 AA Eindhoven (NL); SWANENBERG, Maarten, J., NL-5656 AA Eindhoven (NL); GRAKIST, Alfred, NL-5656 AA Eindhoven (NL); LUDIKHUIZE, Adrianus, W., NL-5656 AA Eindhoven (NL)
(74) Representative: Williamson, Paul Lewis
(86) International application number: PCT/IB2005/053367
(87) International publication number: WO 2006/040736

(56) References cited:
- EP-A- 1 187 220
- US-A- 5 640 040
- US-A- 5 698 869
- US-A- 6 025 237

## Description

This invention relates to a MOSFET suitable for use in high voltage applications and to a method of manufacturing same.

A field-effect transistor (FET) is essentially a semiconductor current path whose conductance is controlled by applying an electric field perpendicular to the current. The electric field results from reverse-biasing a pn junction. A particular type of FET is known as a Metal-Oxide-Semiconductor (MOS) FET, which is a so-called surface FET and is fabricated by diffusing two concentric doped semiconductor regions of a first conductivity type into a lightly doped semiconductor substrate of a second conductivity type.

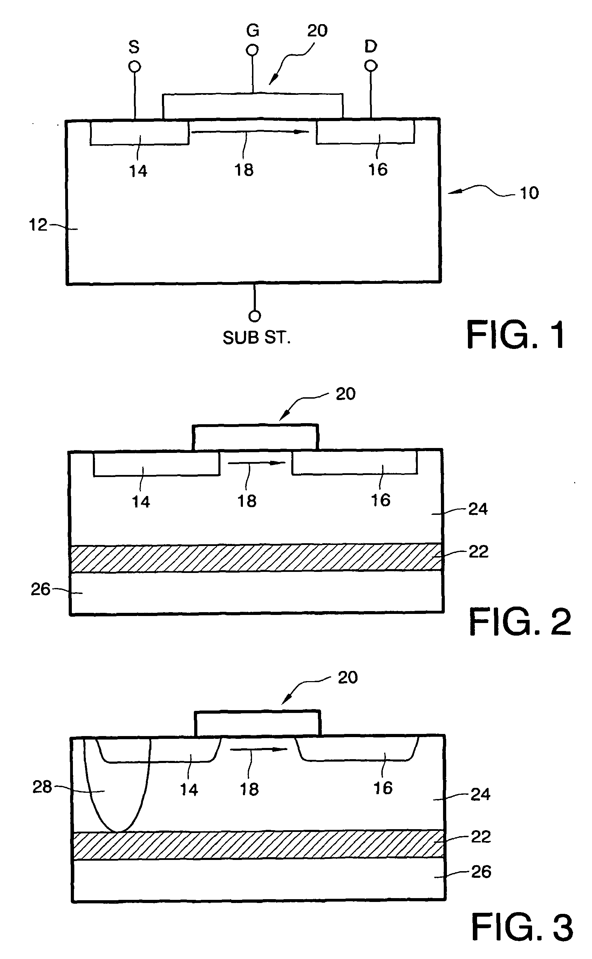

Referring to Fig. 1 for example, a typical, so-called "bulk" PMOS transistor 10 comprises a lightly doped n-type substrate 12, into which two doped p-type semiconductor regions 14, 16 are diffused. The p-type regions 14, 16 form the source and drain of the device, with a channel (denoted by arrow 18) therebetween. The device further comprises a gate region 20. In use, when a voltage is applied between the gate 20 and the substrate, current flows from the source to the drain, across the channel 18.

The bulk MOS structure suffers from the disadvantage that, in a CMOS (Complementary MOS) structure, an n-type region or well of a PMOS device and a p-type region or well of a neighbouring NMOS device effectively form a respective pn junction with the result that a pair of bipolar transistors, one of npn type and the other of pnp type, exist to form a parasitic pnpn thyristor. A phenomenon known as latch-up can occur in respect of this thyristor, whereby it remains conductive and is not restored as a result of, for example, external noise. Thus, the distance between the NMOS and PMOS devices cannot be made too small, because otherwise the gains of the above-mentioned bipolar transistors will be unacceptably high, whereas in an effort to avoid latch-up, the bipolar transistor gains need to be minimised. Accordingly, with the bulk MOS structure, integration density is limited Furthermore, in the bulk MOS structure, all of the source and drain regions have pn junctions formed between the same substrate or wells and the resultant parasitic capacitance created by the pn junctions is highly disadvantageous with regard to high speed operation of the device.

Silicon on insulator (SOI) materials offer potential advantages over bulk materials for the fabrication of high performance integrated circuits, and a method of forming a MOSFET in a monocrystalline semiconductor layer on an insulator is known as an SOI-MOS forming method. Referring to Fig. 2 of the drawings, an SOI-(P)MOS structure is similar in many respects to that of the bulk MOS structure illustrated in Fig. 1, and like elements are denoted by the same reference numerals. However, in this case, the structure comprises a substrate 12 having a buried oxide (BOX) layer 22 therein, in which SOI substrate a lightly-doped n-type semiconductor layer 24 is provided. The shallow p-type source and drain regions 14, 16 are diffused into the n-type semiconductor layer 24, and a gate region 20 is provided as before.

Thus, the MOS device has a relatively thick insulator directly thereunder, and is characterised by its ability to reduce drain junction capacitance and signal line to substrate capacitance to about 1/10 of those of conventional bulk MOS devices. In addition, the MOS is insulated and separated from the supporting substrate, and therefore is also characterised by its ability to substantially eliminate drawbacks caused by irradiation with α rays and latch-up phenomena. Furthermore, silicon dioxide supports much higher voltages than silicon pn-junctions so in the SOI-MOS, SiO₂ isolation between all devices towards the substrate allows for much higher voltage differences in a smaller area, and SOI technology allows MOSFETS to be used at voltages which are negative relative to the handle wafer.

Many applications exist in which a PMOS device is employed which has its source connected to the positive voltage reference (supply) line Vₛ. In relatively high voltage applications, this may cause a problem, because the handle wafer substrate 26 (see Fig. 2) will be at a much lower potential (V_{hw} =0V than the source (which is at Vₛ). As a result, depletion (the phenomena whereby mobile carriers essentially disappear from a region of a semiconductor layer) can occur in the lightly-doped n-type layer 24 of the PMOS device, from the buried oxide layer 22 upward (toward the surface). If Vₛ is lifted too much, an inversion layer can be created at the buried oxide layer 22. Similar, analogous problems exist with NMOS devices which are used at voltages that are negative relative to the handle wafer.

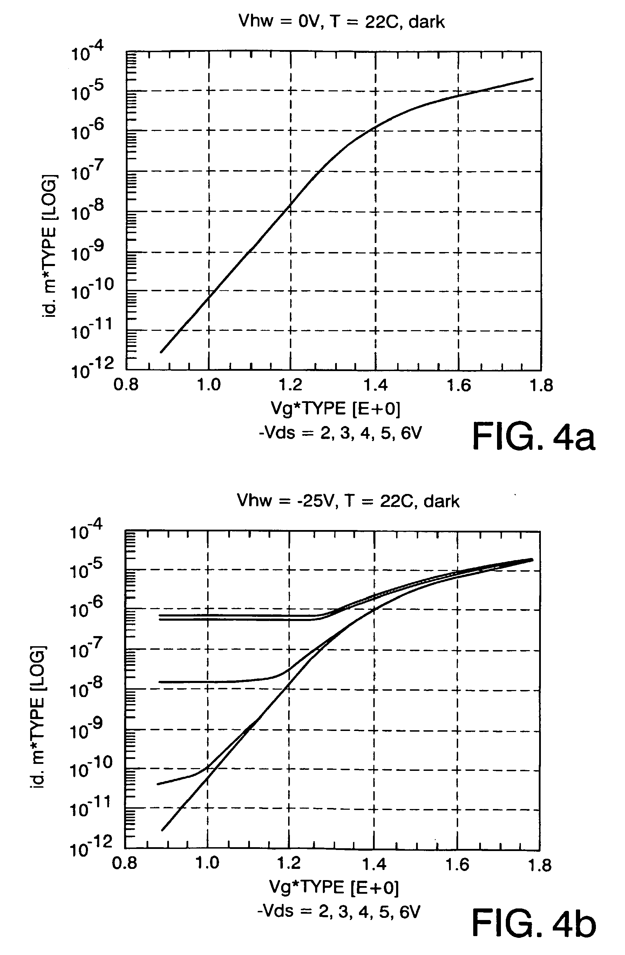

This can cause unacceptably high leakage current from source to drain, which occurs when the above-mentioned depletion layer at the buried oxide layer 22 touches the depletion layer (not shown) extending from the drain region 16 into the n-type region 24 and the source region 14 is in contact with the n-type region 24, or when the depletion layer at the buried oxide layer 22 touches the source region 14. As shown in Figs. 4a and 4b of the drawings, in a PMOS device according to the prior art with an n-type region having a doping dose of 0.9e12/cm², the leakage current increases with the size of the source to drain voltage when the source voltage is lifted above the handle wafer substrate voltage by 25V (Fig. 4b) relative to the case where the source voltage is not lifted above the handle wafer substrate (Fig. 4a). This leakage currently limits the use of PMOS devices to some 20V above V_{hw}, or higher if the doping dose of the n-type region 24 is raised, although even then, the voltage Vₛ-V_{hw} to which the PMOS can be lifted is limited.

US Patent No. 6,225,667 describes an SOI-MOS transistor, wherein the source region extends from a surface of the substrate to the insulating layer, so as to reduce floating body effects of the device (by eliminating the floating source region), which floating body effects can include leakage current from the source to the drain. However, on the other hand, if the devices can be made without body contacts (i.e. the body regions of such devices are kept floating), circuit layout in SOI can be greatly simplified and packing density largely increased.

We have now devised an improved arrangement, and it is an object of the present invention to provide a MOS device, and a method of manufacturing same, whereby the source voltage applied thereto can be lifted significantly (say, 70V or more) above the substrate voltage, without the occurrence of excessive leakage currents.

MOSFETs using a conductive plug at the source region are known from US-5,698,869 and EP-A-1 187 220.

In accordance with the present invention, there is provided a Metal-Oxide-Semiconductor device as claimed in claim 1.

Also in accordance with the present invention, there is provided a method of fabricating a Metal-Oxide-Semiconductor device, the method as claimed in claim 6.

The present invention also extends to an integrated circuit including a MOS device as defined above.

Preferably, the plug region extends from said surface of said device at said source region to said layer of insulating material.

The provision of the plug at the source region, between the surface of the device and the insulating layer, provides the above-mentioned inversion layer with charge carriers (so as to prevent it from reaching the diffused source region or the depletion region of the drain region) and fixes the electrical potential at the source voltage Vₛ.

In a preferred embodiment, the MOS device comprises a PMOS transistor, wherein said first conductivity type is n-type and said second conductivity type is p-type. However, the MOS device may equally be an NMOS transistor. Preferably, said layer of insulating material is a buried insulating layer, for example, a buried oxide layer.

The plug region is required to have the same electrical potential as the source region, i.e. it needs to be shorted electrically. This may be achieved by means of a metal contact, or the like, or by overlapping dope.

The plug region at least partially overlaps said source region. The extent of the overlap should be sufficient to cope with processing variations. In one specific exemplary embodiment of the invention, the semiconductor material of said second conductivity type may be doped with any suitable dopant, for example, phosphorous (the atoms of which are relatively light so it is easily implanted down to a depth of a few microns), possibly with a doping dose in the range of around 0.1e12/cm² to 3e12/cm².

These and other aspects will be apparent from, and elucidated with reference to, the embodiment described herein.

An embodiment of the present invention will now be described by way of example only and with reference to the accompanying drawings, in which:
Fig. 1 is a schematic cross-sectional view of a bulk MOS device according to the prior art;
Fig. 2 is a schematic cross-sectional view of an SOI-MOS device according to the prior art;
Fig. 3 is a schematic cross-sectional view illustrating the configuration of an SOI-MOS device according to an exemplary embodiment of the present invention;
Figs. 4a and 4b illustrate graphically leakage current vs. gate voltage in respect of a PMOS transistor according to the prior art having an n-type region with a doping dose of 0.9e12/cm² when the source voltage is not lifted above the handle wafer substrate voltage (Fig. 4a) and when the source voltage is lifted above the handle wafer substrate voltage by 25V (i.e Vₛ-V_{hw} = 25V), in the case where the source to drain voltage V_{ds}=2, 3, 4, 5, 6V;
Fig. 5a illustrates graphically drain current vs. gate voltage of a PMOS transistor according to the prior art having an n-type region with a doping dose of 3e12/em², wherein the source voltage is not lifted above the handle wafer substrate voltage, in the case where V_{ds}=2, 3, 4, 5, 6V;
Fig. 5b illustrates graphically the drain current vs. gate voltage of the PMOS transistor to which Fig. 5a relates, wherein the source voltage has been lifted above the handle wafer substrate voltage by 120V (i.e. Vₛ-V_{hw} = 120V) in the case where V_{ds}=2, 3, 4, 5, 6V;
Fig. 5c illustrates graphically the drain current vs. gate voltage of the PMOS transistor to which Fig. 5a relates, wherein the source voltage has been lifted above the handle wafer substrate voltage by 180V (i.e. Vₛ-V_{hw} = 180V) in the case where V_{ds}=2, 3, 4, 5, 6V;
Fig. 6a illustrates graphically drain current vs. gate voltage of a PMOS transistor according to an exemplary embodiment of the present invention, wherein the source voltage has not been lifted above the handle wafer substrate voltage, in the case where V_{ds}=2, 3, 4, 5, 6V;
Fig. 6b illustrates graphically the drain current vs. the gate voltage of the PMOS transistor to which Fig. 6a relates, wherein the source voltage has been lifted above the handle wafer substrate voltage by 180V (i.e. Vₛ-V_{hw} = 180V) in the case where V_{ds}=2, 3, 4, 5, 6V; and
Fig. 7 illustrates graphically the response of the device to which Fig. 6a relates, wherein the source voltage = 0V and V_{hw} = -120V and the source to drain voltage V_{ds} =0, -2, -4, -6, -8, -10V, wherein it can be seen that there is a slight current leakage of 0.2µA at V_{ds}=-10V with a first signature at -8V.

As explained above, it is an object of the present invention to provide a MOS device, and a method of manufacturing same, whereby the source voltage applied thereto can be lifted significantly (say, 70V or more) above the substrate voltage, without the occurrence of excessive leakage currents.

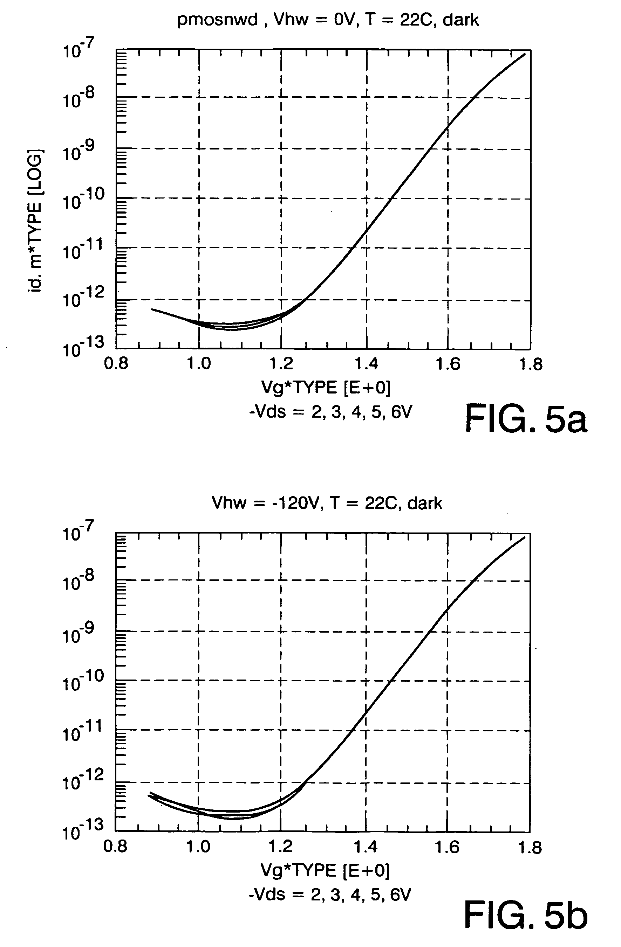

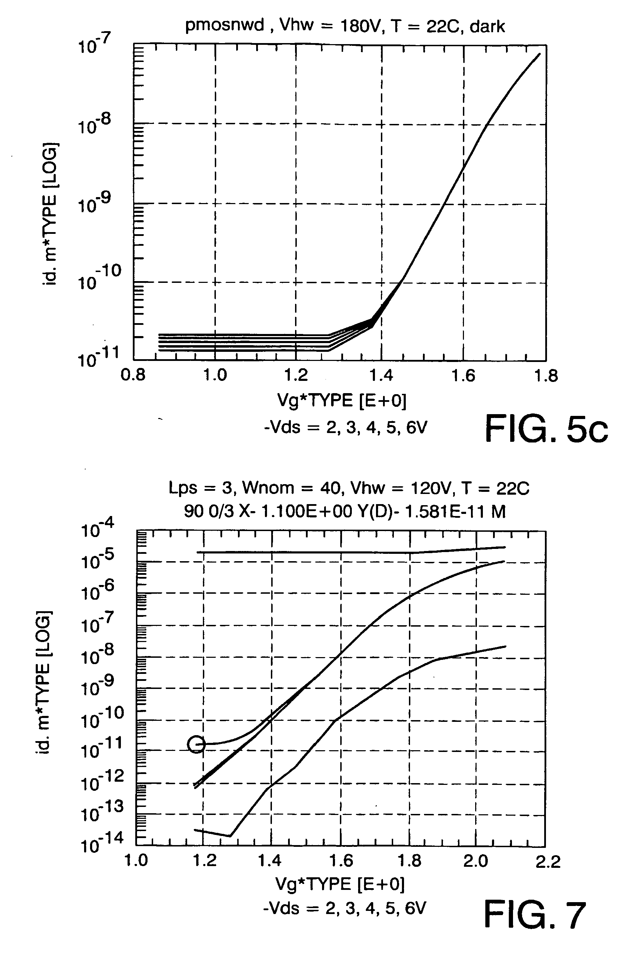

If the doping dose of the n-type region is increased, say, to 3e12/cm² (Fig. 5a) then it may be possible to lift the source voltage to a certain extent, without excessive leakage currents occurring (see Fig. 5b). However, although Fig. 5b illustrates that, in this case, the source voltage can be lifted by 120V without the occurrence of excessive leakage currents, this is neither a stable nor well-defined situation over time as no charge barriers are provided to form an inversion layer other than by the charge carrier generation process, as has been shown in time-dependent capacitances in SOI. In any event, as shown in Fig. 5c, the same device cannot have the source voltage lifted to (say) 180V without the occurrence of excessive leakage currents.

Referring to Fig. 3 of the drawings, a PMOS transistor according to an exemplary embodiment of the present invention comprises an SOI substrate 26 having a buried oxide layer 22 as before, over which is provided an n-type well region 24. Within the well region 24, p-type semiconductor regions are provided, by diffusion, to form respective source and drain regions 14, 16. A channel is defined between the source and drain regions 14, 16 and a gate region 20 is provided.

In order to achieve the above-mentioned object of the present invention, a deep plug 28 of doped p-type semiconductor material is provided, by diffusion, within the n-type region 24 at the source region 14, which plug 28 extends from the surface of the device to the buried oxide layer 22. As shown, in the embodiment, the plug 28 at least partially overlaps the source region 14.

The plug 28 has the effect of providing the inversion layer, formed from the buried oxide layer 22 upward when the source voltage Vₛ is lifted above the handle wafer substrate voltage

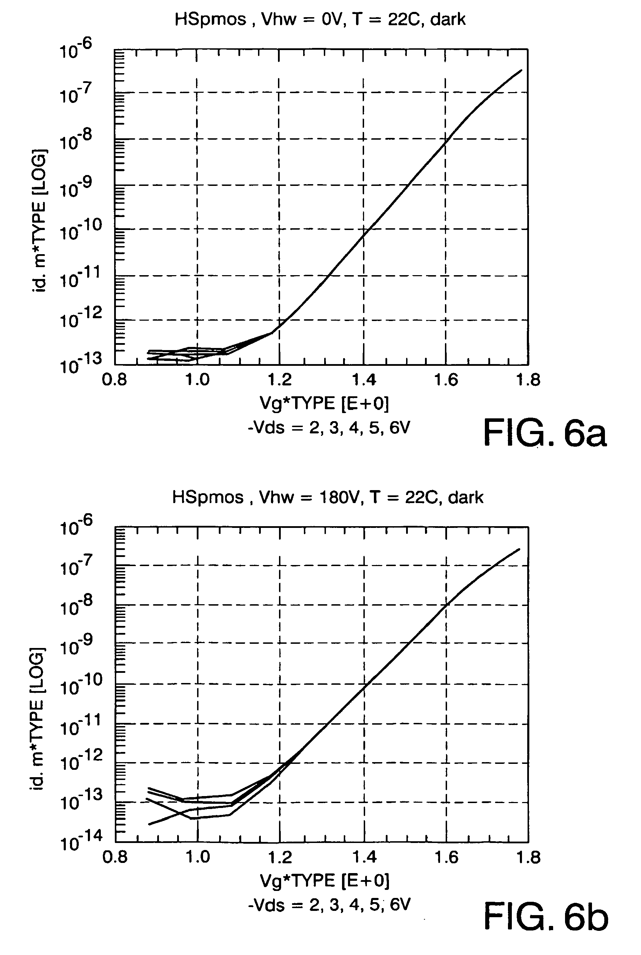

V_{hw} by more than some threshold voltage, with charge carriers, thereby fixing the electrical potential at the source voltage Vₛ. Referring to Fig. 6a of the drawings, there is illustrated graphically the drain current of a PMOS transistor according to an exemplary embodiment of the present invention vs. the gate voltage when the difference between the source voltage and the handle wafer substrate voltage is substantially zero. Now consider Fig. 6b, which illustrates graphically the drain current vs. the gate voltage of the same PMOS transistor when the source voltage is lifted by 180V above the handle wafer substrate voltage, indicating insignificant increase in leakage. This is achieved because, as a result of the provision of the plug 28, when the source voltage is lifted further above the handle wafer substrate voltage, the depletion layer from the buried oxide layer 22 upward is prevented from growing beyond a certain point, but is instead fixed as the field over the buried oxide layer 22 is fixed by Vₛ-V_{hw}. Thus, even lifting the source voltage of the PMOS transistor by 180V does not increase leakage current significantly.

If the source-drain voltage is then increased, only the depletion layer at the drain region 16 will extend until the limit is reached where it touches the depletion layer at the buried oxide layer 22. In the illustrated example, this happens at about 8 to 9V, as can be seen from the subthreshold leakage current graph of Fig. 7, which confirms the effectiveness of the proposed mechanism.

If the plug region were to be provided at the drain region 16 instead of the source region 14, a full inversion layer may still be prevented from forming at the buried oxide layer 22 because the positive charges will not stay on the buried oxide layer 22 to form a complete inversion layer, but will instead flow to the most negative point, i.e. the drain. However, leakage current from source to drain will flow if the depletion layer from the buried oxide layer 22 touches the source region 14. In this case, the device cannot be lifted more than some 70V with an n-type region doping dose of 3e12/cm² before leakage will occur from source to drain.

In general, the doping dose for the plug region needs to be sufficient to overdope the well down to the insulator interface.

It should be noted that the above-mentioned embodiment illustrates rather than limits the invention, and that those skilled in the art will be capable of designing many alternative embodiments without departing from the scope of the invention as defined by the appended claims. In the claims, any reference signs placed in parentheses shall not be construed as limiting the claims. The word "comprising" and "comprises", and the like, does not exclude the presence of elements or steps other than those listed in any claim or the specification as a whole. The singular reference of an element does not exclude the plural reference of such elements and vice-versa. The invention may be implemented by means of hardware comprising several distinct elements, and by means of a suitably programmed computer. In a device claim enumerating several means, several of these means may be embodied by one and the same item of hardware. The mere fact that certain measures are recited in mutually different dependent claims does not indicate that a combination of these measures cannot be used to advantage.

## Claims

1. A Metal-Oxide-Semiconductor device comprising a semiconductor-on-insulator substrate (26) having a layer (22) of insulating material over which is provided a doped semiconductor region (24) of a first conductivity type, a gate region (20) of said first conductivity type, a source region (14) and drain region (16) being provided at a surface of said device within said doped semiconductor region (24) of said first conductivity type, said source and drain regions (14, 16) comprising respective doped semiconductor regions of a second conductivity type and defining a channel therebetween, wherein a gap is provided between said source and drain regions (14, 16) and said layer (22) of insulating material,
**characterised in that** the device further comprises a doped semiconductor plug region (28) of said second conductivity type extending from said surface of said device at or adjacent said source region (14) into said doped semiconductor region (24) of said first conductivity type and being electrically shorted to said source region (14), and wherein said plug region (28) at least partially overlaps said source region (14), wherein the doped semiconductor plug region (28) is adapted to provide an inversion layer when the source voltage is lifted above the substrate voltage by more than some threshold voltage, with charge carriers, thereby fixing the electrical potential at the source voltage and to prevent the depletion layer formed from said layed (22) of insulating material upward from growing upward beyond a certain point.

2. A device according to claim 1, wherein said plug region (28) extends from said surface of said device to said layer (22) of insulating material.

3. A device according to claim 1, comprising a PMOS transistor, wherein said first conductivity type is n-type and said second conductivity type is p-type.

4. A device according to claim 1, comprising an NMOS transistor, wherein said first conductivity type is p-type and said second conductivity type is n-type.

5. A device according to claim 1, wherein said plug region (28) is electrically shorted to said source region (14) by means of a conductive contact.

6. A method of fabricating a Metal-Oxide-Semiconductor device, the method comprising providing a semiconductor-on- insulator substrate (26) having a layer of insulating material (22) over which is provided a doped semiconductor region (24) of a first conductivity type, providing a gate region (20) of said first conductivity type, providing by diffusion a source region (14) and drain region (16) at a surface of said device within said doped semiconductor region (24) of said first conductivity type, said source and drain regions (14, 16) comprising respective doped semiconductor regions of a second conductivity type and defining a channel therebetween, wherein a gap is provided between said source and drain regions (14, 16) and said layer of insulating material (22),
**characterised in that** the method further comprises forming a doped semiconductor plug region (28) of said second conductivity type by diffusion which extends from said surface of said device at or adjacent said source region (14) into said doped semiconductor region (24) of said first conductivity type and being electrically shorted to said source region (14), and wherein said plug region (28) at least partially overlaps said source region (14), wherein the doped semiconductor plug region (28) is designed to provide an inversion layer when the source voltage is lifted above the substrate voltage by more than a threshold voltage, with charge carriers, thereby fixing the electrical potential at the source voltage and to prevent the depletion layer formed from said layer (22) of insulating material upward from growing upward beyond a certain point.

7. An integrated circuit including a MOS device according to claim 1.

## Patentansprüche

1. Metalloxid-Halbleiter-Gerät, aufweisend ein Halbleiter-auf Isolator-Substrat (26), welches eine Schicht (22) von isolierendem Material hat, über welchem ein dotierter Halbleiterbereich (24) eines ersten Leitfähigkeitstyps bereitgestellt ist, einen Gate-Bereich (20) des ersten Leitfähigkeitstyps, einen Source-Bereich (14) und einen Drain-Bereich (16), welcher bei einer Oberfläche des Geräts innerhalb des dotierten Halbleiterbereichs (24) des ersten Leitfähigkeitstyps bereitgestellt ist, wobei der Source- und der Drain-Bereich (14, 16) jeweils einen dotierten Halbleiterbereich eines zweiten Leitfähigkeitstyps aufweisen und einen Kanal dazwischen definieren, wobei ein Spalt zwischen den Source- und Drain-Bereichen (14, 16) und der Schicht (22) von isolierendem Material bereitgestellt ist,
**dadurch gekennzeichnet, dass**
das Gerät ferner einen dotierten Halbleiter-Steckbereich (28) des zweiten Leitfähigkeitstyps aufweist, welcher sich von der Oberfläche des Gerätes bei oder angrenzend an den Source-Bereich (14) in den dotierten Halbleiterbereich (24) des ersten Leitfähigkeitstyps erstreckt und elektrisch mit dem Source-Bereich (14) kurzgeschlossen ist, und wobei der Steckbereich (28) zumindest teilweise den Source-Bereich (14) überlappt, wobei der dotierte Halbleiter-Steckbereich (8) ausgebildet ist, eine Inversionsschicht bereitzustellen, wenn die Source-Spannung über die Substrat-Spannung um mehr als eine gewisse Schwellspannung angehoben ist, mit Ladungsträgern, um dadurch das elektrische Potential bei der Source-Spannung zu fixieren und zu verhindern, dass die Depletionsschicht, welche von der Schicht (22) von isolierendem Material nach oben gebildet ist, nach oben über einen gewissen Punkt hinaus wächst.

2. Gerät gemäß Anspruch 1, wobei sich der Steckbereich (28) von der Oberfläche des Geräts zu der Schicht (22) von isolierendem Material erstreckt.

3. Gerät gemäß Anspruch 1, aufweisend einen PMOS-Transistor, wobei der erste Leitfähigkeitstyp ein n-Typ ist und wobei der zweite Leitfähigkeitstyp ein p-Typ ist.

4. Gerät gemäß Anspruch 1, aufweisend einen NMOS-Transistor, wobei der erste Leitfähigkeitstyp ein p-Typ ist und wobei der zweite Leitfähigkeitstyp ein n-Typ ist.

5. Gerät gemäß Anspruch 1, wobei der Steckbereich (28) elektrisch mit dem Source-Bereich (14) mittels eines leitfähigen Kontakts kurzgeschlossen ist.

6. Verfahren zum Herstellen eines Metalloxid-Halbleitergeräts, wobei das Verfahren aufweist Bereitstellen eines Halbleiter-auf-Isolator-Substrats (26), welches eine Schicht von isolierendem Material (22) hat, über dem ein dotierter Halbleiterbereich (24) eines ersten Leitfähigkeitstyps bereitgestellt ist, Bereitstellen eines Gate-Bereichs (20) des ersten Leitfähigkeitstyps, mittels Diffusion Bereitstellen eines Source-Bereichs (14) und eines Drain-Bereichs (16) bei einer Oberfläche des Geräts innerhalb des dotierten Halbleiterbereichs (24) des ersten Leitfähigkeitstyps, wobei der Source- und Drain-Bereich (14, 16) jeweils einen dotierten Halbleiterbereich eines zweiten Leitfähigkeitstyps aufweisen und einen Kanal dazwischen definieren, wobei ein Spalt zwischen den Source- und Drain-Bereichen (14, 16) und der Schicht von isolierendem Material (22) bereitgestellt ist,
**dadurch gekennzeichnet, dass** das Verfahren ferner aufweist Bilden eines dotierten Halbleiter-Steckbereichs (28) des zweiten Leitfähigkeitstyps mittels Diffusion, welcher sich von der Oberfläche des Geräts bei oder angrenzend an den Source-Bereich (14) in den dotierten Halbleiterbereich (24) des ersten Leitfähigkeitstyps erstreckt und welcher elektrisch mit dem Source-Bereich (14) kurzgeschlossen ist, und wobei der Steckbereich (28) zumindest teilweise den Source-Bereich (14) überlappt, wobei der dotierte Halbleiter-Steckbereich (28) ausgebildet ist, eine Inversionsschicht bereitzustellen, wenn die Source-Spannung über die Substrat-Spannung um mehr als eine Schwellwert-Spannung angehoben wird, mit Ladungsträgern, um dadurch das elektrische Potential bei der Source-Spannung zu fixieren und zu verhindern, dass die Depletionsschicht, welche von der Schicht (22) von isolierendem Material nach oben gebildet ist, nach oben über einen gewissen Punkt hinaus wächst.

7. Integrierte Schaltung, welche ein MOS-Gerat gemäß Anspruch 1 umfasst.

## Revendications

1. Dispositif métal-oxyde-semi-conducteur comprenant un substrat de semi-conducteur sur isolant (26) ayant une couche (22) de matériau isolant sur laquelle est disposée une région de semi-conducteur dopé (24) d'un premier type de conductivité, une région de grille (20) dudit premier type de conductivité, une région de source (14) et une région de drain (16) étant disposées sur la surface dudit dispositif dans ladite région de semi-conducteur dopé (24) dudit premier type de conductivité, lesdites régions de source et de drain (14, 16) comprenant des régions respectives de semi-conducteur dopé d'un deuxième type de conductivité et définissant un canal entre elles, dans lequel un intervalle est disposé entre lesdites régions de source et de drain (14, 16) et ladite couche (22) de matériau isolant,
**caractérisé par le fait que** le dispositif comporte en outre une région de bouchon de semi-conducteur dopé (28) dudit deuxième type de conductivité s'étendant de ladite surface dudit dispositif dans ladite région de source (14) ou adjacente à celle-ci dans ladite région de semi-conducteur dopé (24) du premier type de conductivité et étant en court circuit avec ladite région de source (14), et dans lequel ladite région de bouchon (28) recouvre au moins partiellement ladite région de source (14), dans lequel ladite région de bouchon de semi-conducteur dopé (28) est agencée de manière à fournir une couche d'inversion lorsque la tension de source est tirée au-dessus de la tension du substrat d'une quantité supérieure à une certaine tension de seuil, avec des porteurs de charge, fixant ainsi le potentiel électrique à la tension de source et évitant que la couche d'appauvrissement formée vers le haut à partir de ladite couche (22) de matériau isolant ne croisse vers le haut au-delà d'un certain point.

2. Dispositif selon la revendication 1, dans lequel ladite région de bouchon (28) s'étend à partir de ladite surface dudit dispositif jusqu'à ladite couche (22) de matériau isolant.

3. Dispositif selon la revendication 1, comprenant un transistor PMOS, dans lequel ledit premier type de conductivité est un type n et ledit deuxième type de conductivité est un type p.

4. Dispositif selon la revendication 1, comprenant un transistor NMOS, dans lequel ledit premier type de conductivité est un type p et ledit deuxième type de conductivité est un type n.

5. Dispositif selon la revendication 1, dans lequel ladite région de bouchon (28) est mise en court-circuit électrique avec ladite région de source (14) à l'aide d'un contact conducteur.

6. Procédé de fabrication d'un dispositif métal-oxyde-semi-conducteur, le procédé comprenant la mise en place d'un substrat de semi-conducteur sur isolant (26) ayant une couche (22) de matériau isolant sur laquelle est disposée une région de semi-conducteur dopé (24) d'un premier type de conductivité, la mise en place d'une région de grille (20) dudit premier type de conductivité, la mise en place par diffusion d'une région de source (14) et d'une région de drain (16) sur la surface dudit dispositif dans ladite région de semi-conducteur dopé (24) dudit premier type de conductivité, lesdites régions de source et de drain (14, 16) comprenant des régions respectives de semi-conducteur dopé d'un deuxième type de conductivité et définissant un canal entre elles, dans lequel un intervalle est disposé entre lesdites régions de source et de drain (14, 16) et ladite couche (22) de matériau isolant,
**caractérisé par le fait que** le procédé comporte en outre la formation par diffusion d'une région de bouchon de semi-conducteur dopé (28) dudit deuxième type de conductivité s'étendant de ladite surface dudit dispositif dans ladite région de source (14) ou adjacente à celle-ci dans ladite région de semi-conducteur dopé (24) du premier type de conductivité et étant en court circuit avec ladite région de source (14), et dans lequel ladite région de bouchon (28) recouvre au moins partiellement ladite région de source (14), dans lequel ladite région de bouchon de semi-conducteur dopé (28) est agencée de manière à fournir une couche d'inversion lorsque la tension de source est tirée au-dessus de la tension du substrat d'une quantité supérieure à une certaine tension de seuil, avec des porteurs de charge, fixant ainsi le potentiel électrique à la tension de source et évitant que la couche d'appauvrissement formée vers le haut à partir de ladite couche (22) de matériau isolant ne croisse vers le haut au-delà d'un certain point.

7. Circuit intégré comprenant un dispositif MOS selon la revendication 1.
